# EUROPEAN PATENT SPECIFICATION

(11) **EP 4 531 518 B1**
(45) Date of publication and mention of the grant of the patent: **22.04.2026**
(21) Application number: 24200986.8
(22) Date of filing: 18.09.2024
(51) Int. Cl.: H10D 30/67, H10D 86/40, H10D 64/62

(54) **SEMICONDUCTOR DEVICE**
HALBLEITERANORDNUNG
DISPOSITIF SEMI-CONDUCTEUR

(30) Priority: 29.09.2023 JP 2023169618
(43) Date of publication of application: 02.04.2025
(73) Proprietor: Japan Display Inc., Tokyo 105-0003 (JP); Idemitsu Kosan Co., Ltd., Tokyo 100-8321 (JP)
(72) Inventor: WATAKABE, Hajime, Tokyo, 105-0003 (JP); TSUBUKU, Masashi, Tokyo, 105-0003 (JP); MIURA, Kentaro, Tokyo, 105-0003 (JP); WATABE, Masahiro, Tokyo, 105-0003 (JP)
(74) Representative: MERH-IP Matias Erny Reichl Hoffmann Patentanwälte PartG mbB

(56) References cited:
- US-A1- 2020 373 433
- US-B2- 9 905 579

## Description

### TECHNICAL FIELD

An embodiment of the present invention relates to a semiconductor device.

### BACKGROUND ART

In recent years, a semiconductor device has been developed in which transistors made of different semiconductor materials are formed on the same substrate as a semiconductor layer. For example, a transistor using silicon is used as a transistor requiring high-speed operation, and a transistor using an oxide semiconductor is used as a transistor requiring a switching operation, so that transistors having different characteristics depending on a required function can be formed on the same substrate.

Patent Literature 1 discloses a display device in which a transistor in which silicon is used for a driving circuit is formed on the same substrate, and a transistor in which an oxide semiconductor is used for a display region is formed.

### CITATION LIST

### PATENT LITERATURE

Patent Literature 1: Japanese laid-open patent publication No. 2018-128693

### SUMMARY OF INVENTION

### TECHNICAL PROBLEM

An object of an embodiment of the present invention is to provide a highly productive semiconductor device that achieves good characteristics for each transistor having different characteristics.

### SOLUTION TO PROBLEMS

The subject matter of the present invention is defined in claim 1. semiconductor device according to an embodiment of the present invention includes: a first semiconductor layer; a first gate electrode facing the first semiconductor layer; a first gate insulating layer between the first semiconductor layer and the first gate electrode; a first insulating layer arranged above the first gate electrode; a first electrode arranged in a region overlapping the first semiconductor layer in a plan view, and electrically connected to the first semiconductor layer; a second semiconductor layer arranged above the first insulating layer and made of a different material from the first semiconductor layer; a second gate electrode facing the second semiconductor layer; a second gate insulating layer between the second semiconductor layer and the second gate electrode; a second electrode arranged in a region overlapping the second semiconductor layer in a plan view, and electrically connected to the second semiconductor layer; and a first metal nitride layer between the second semiconductor layer and the second electrode, wherein the second semiconductor layer is polycrystalline, and an etching rate of the second semiconductor layer with respect to an etchant including phosphoric acid as a main component is less than 3 nm/min at 40 °C.

### BRIEF DESCRIPTION OF DRAWINGS

FIG. 1 is a plan view illustrating a semiconductor device according to an embodiment of the present invention.
FIG. 2 is a cross-sectional view illustrating a semiconductor device according to an embodiment of the present invention.
FIG. 3 is a cross-sectional view illustrating a method for manufacturing a semiconductor device according to an embodiment of the present invention.
FIG. 4 is a cross-sectional view illustrating a method for manufacturing a semiconductor device according to an embodiment of the present invention.
FIG. 5 is a cross-sectional view illustrating a method for manufacturing a semiconductor device according to an embodiment of the present invention.
FIG. 6 is a cross-sectional view illustrating a method for manufacturing a semiconductor device according to an embodiment of the present invention.
FIG. 7 is a cross-sectional view illustrating a semiconductor device according to an embodiment of the present invention.
FIG. 8 is a cross-sectional view illustrating a method for manufacturing a semiconductor device according to an embodiment of the present invention.
FIG. 9 is a cross-sectional view illustrating a method for manufacturing a semiconductor device according to an embodiment of the present invention.
FIG. 10 is a cross-sectional view illustrating a method for manufacturing a semiconductor device according to an embodiment of the present invention.
FIG. 11 is a cross-sectional view illustrating a method for manufacturing a semiconductor device according to an embodiment of the present invention.
FIG. 12 is a cross-sectional view illustrating a semiconductor device according to an embodiment of the present invention.
FIG. 13 is a cross-sectional view illustrating a method for manufacturing a semiconductor device according to an embodiment of the present invention.
FIG. 14 is a cross-sectional view illustrating a method for manufacturing a semiconductor device according to an embodiment of the present invention.
FIG. 15 is a cross-sectional view illustrating a method for manufacturing a semiconductor device according to an embodiment of the present invention.
FIG. 16 is a cross-sectional view illustrating a semiconductor device according to an embodiment of the present invention.
FIG. 17 is a cross-sectional view illustrating a method for manufacturing a semiconductor device according to an embodiment of the present invention.
FIG. 18 is a cross-sectional view illustrating a method for manufacturing a semiconductor device according to an embodiment of the present invention.
FIG. 19 is a cross-sectional view illustrating a method for manufacturing a semiconductor device according to an embodiment of the present invention.
FIG. 20 is a cross-sectional view illustrating a semiconductor device according to an embodiment of the present invention.

### DESCRIPTION OF EMBODIMENTS

Hereinafter, embodiments of the present invention will be described with reference to the drawings. The following disclosure is merely an example. For clarity of explanation, the drawings may be schematically represented with respect to widths, thicknesses, shapes, and the like of respective portions as compared with actual embodiments. However, the illustrated shapes are merely examples, and do not limit the interpretation of the present invention. In the present specification and the drawings, the same reference signs are given to the same components as those described above with respect to the above-described drawings, and detailed description thereof may be omitted as appropriate.

In the embodiments of the present invention, a direction from a substrate toward an oxide semiconductor layer is referred to as upper or above. Conversely, a direction from the oxide semiconductor layer to the substrate is referred to as lower or below. In this way, for convenience of explanation, the phrase "above" or "below" is used for explanation, but for example, the vertical relationship between the substrate and the oxide semiconductor layer may be different from that shown in the drawings. In the following explanation, for example, the expression "oxide semiconductor layer on a substrate" merely describes the vertical relationship between the substrate and the oxide semiconductor layer as described above, and another member may be arranged between the substrate and the oxide semiconductor layer. The terms "above" or "below" mean a stacking order in a structure in which a plurality of layers is stacked, and when expressed as a pixel electrode above a transistor, it may be a positional relationship in which the transistor and the pixel electrode do not overlap in a plan view. On the other hand, when expressed as a pixel electrode vertically above a transistor, it means a positional relationship in which the transistor and the pixel electrode overlap in a plan view.

In the present specification, the terms "film" and "layer" can optionally be interchanged with one another.

"Display device" refers to a structure that displays an image using an electro-optic layer. For example, the term "display device" may refer to a display panel that includes the electro-optic layer, or may refer to a structure with other optical members (for example, a polarized member, a backlight, a touch panel, and the like) attached to a display cell. "Electro-optical layer" may include a liquid crystal layer, an electroluminescent (EL) layer, an electrochromic (EC) layer, or an electrophoretic layer, as long as no technical contradiction is caused. Therefore, although a display device will be described by exemplifying a liquid crystal display device including a liquid crystal layer and an organic EL display device including an organic EL layer for the embodiments described later, the structure according to the present embodiment can be applied to a display device including other electro-optical layers described above.

In the present specification, the expressions "α includes A, B, or C," "α includes any of A, B, and C," and "α includes one selected from a group consisting of A, B, and C," do not exclude the case where α includes a plurality of combinations of A to C unless otherwise specified. Furthermore, these expressions do not exclude the case where α includes other elements.

The following embodiments can be combined with each other as long as there is no technical contradiction.

### [1. First Embodiment]

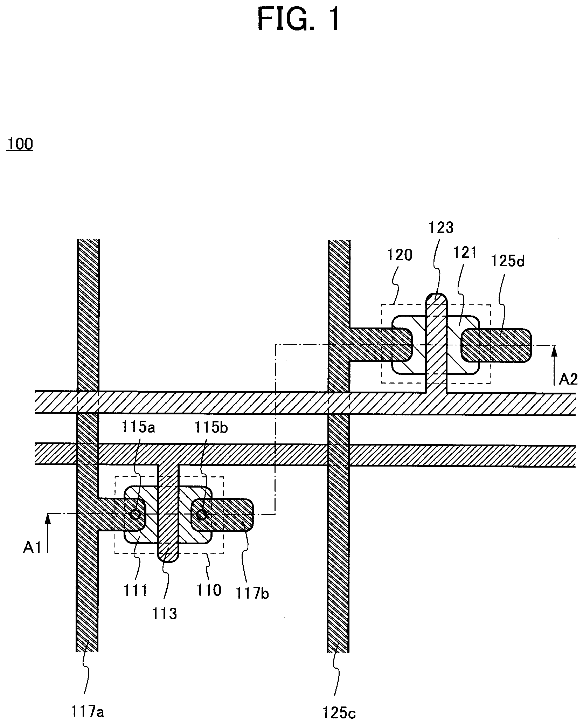

An example of a structure of a semiconductor device 100 according to an embodiment of the present invention will be described with reference to FIG. 1 to FIG. 6.

### [1-1. Configuration of Semiconductor Device]

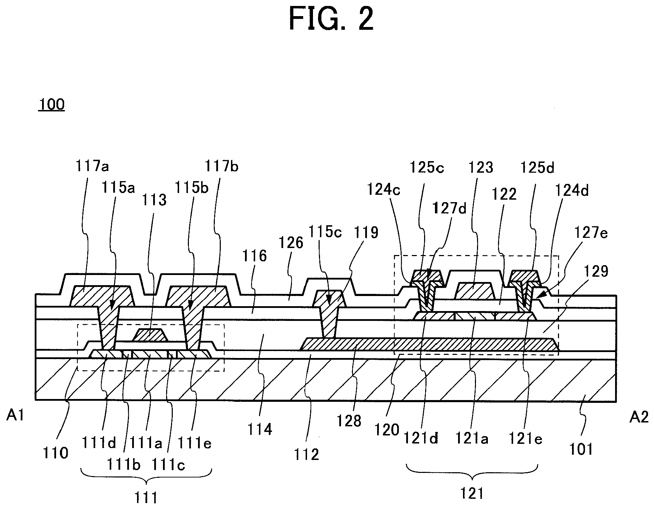

FIG. 1 is a plan view of the semiconductor device 100 according to an embodiment of the present invention. FIG. 2 is a cross-sectional view when the semiconductor device 100 shown in FIG. 1 is cut along a line A1-A2. As shown in FIG. 1 and FIG. 2, the semiconductor device 100 according to an embodiment of the present invention includes a transistor 110 and a transistor 120 arranged on the transistor 110.

The transistor 110 includes a semiconductor layer 111, a gate insulating layer 112, and a gate electrode 113.

Either an N-type transistor or a P-type transistor may be used as the transistor 110. In the present embodiment, an example in which a top-gate type N-type transistor in which polysilicon is used for a semiconductor layer is used as the transistor 110 will be described.

The semiconductor layer 111 in the N-type transistor includes a channel region 111a, a source region 111d, a drain region 111e, and low-concentration impurity regions 111b and 111c. The low-concentration impurity region 111b is arranged between the channel region 111a and the source region 111d. The low-concentration impurity region 111c is arranged between the channel region 111a and the drain region 111e. The source and the drain may be interchanged depending on the operation of the transistor 110. That is, the region 111d may function as the drain region, and the region 111e may function as the source region.

The semiconductor layer 111 in the channel region 111a has semiconductor properties. That is, depending on a voltage applied to the gate electrode 113, the semiconductor layer 111 in the channel region 111a is switched between a state functioning as a current path and a state not functioning as a current path. The carrier concentration in the semiconductor layer 111 in the source region 111d and the drain region 111e is greater than the carrier concentration in the semiconductor layer 111 in the channel region 111a.

Interlayer insulating layers 114 and 116 are arranged on the transistor 110. A source electrode 117a and a drain electrode 117b are arranged on the interlayer insulating layers 114 and 116. The source electrode 117a and the drain electrode 117b are connected to the source region 111d and the drain region 111e via openings 115a and 115b arranged in the interlayer insulating layers 114 and 116.

The transistor 120 is arranged in a region different from a region where the transistor 110 is arranged. The transistor 120 includes an oxide semiconductor layer 121, a gate insulating layer 122, a gate electrode 123, a gate electrode 128, and a gate insulating layer 129. An interlayer insulating layer 126 is arranged on the gate electrode 123. Although details will be described later, the oxide semiconductor layer 121 is polycrystalline.

The gate electrode 128 is arranged between the gate insulating layer 112 and the interlayer insulating layer 114. The gate electrode 128 is arranged in a region that overlaps the oxide semiconductor layer 121 (in particular, a channel region 121a) in a plan view. A wiring 119 is arranged on the interlayer insulating layers 114 and 116. The wiring 119 is connected to the gate electrode 128 via an opening 115c arranged in each of the interlayer insulating layers 114 and 116. The wiring 119 is in the same layer as the source electrode 117a and the drain electrode 117b. In other words, the wiring 119 is in contact with the interlayer insulating layer 116 in the same manner as the source electrode 117a and the drain electrode 117b.

The channel region 121a, a source region 121d, and a drain region 121e are arranged in the oxide semiconductor layer 121. The source region 121d and the drain region 121e are adjacent to the channel region 121a. In a plan view, the channel region 121a overlaps the gate electrode 123.

The oxide semiconductor layer 121 of the channel region 121a has semiconductor properties. That is, depending on a voltage applied to the gate electrodes 123 and 128, the oxide semiconductor layer 121 of the channel region 121a is switched between a state functioning as a current path and a state not functioning as a current path. The carrier concentration in the oxide semiconductor layer 121 in the source region 121d and the drain region 121e is greater than the carrier concentration in the oxide semiconductor layer 121 in the channel region 121a.

For example, the sheet resistance of the oxide semiconductor layer 121 in the source region 121d and the drain region 121e is 1000 Ω/sq. or less, preferably 500 Ω/sq. or less, and more preferably 250 Ω/sq. or less. In other words, the oxide semiconductor layer 121 in the channel region 121a has a higher electrical resistance (or lower electrical conductivity) than the oxide semiconductor layer 121 in each of the source region 121d and the drain region 121e.

A voltage for controlling the channel region 121a is supplied to the gate electrodes 123 and 128, respectively. That is, in the present embodiment, a dual-gate transistor in which an N-type oxide semiconductor is used is exemplified as the transistor 120. However, the transistor 120 may be a bottom-gate transistor in which only the gate electrode 128 is arranged, or may be a top-gate transistor in which only the gate electrode 123 is arranged.

Openings 127d and 127e that reach each of the source region 121d and the drain region 121e of the oxide semiconductor layer 121 are arranged in the gate insulating layer 122 and the interlayer insulating layer 126. Metal nitride layers 124c and 124d are arranged inside the opening 127d, inside the opening 127e, and on the source region 121d and the drain region 121e. The metal nitride layers 124c and 124d are in contact with an upper surface of the oxide semiconductor layer 121 and an upper surface of the interlayer insulating layer 126. The source electrode 125c and the drain electrode 125d are arranged inside the opening 127d, inside the opening 127e, and on the metal nitride layers 124c and 124d.

With regards to the above configuration, the semiconductor layer 111 may be referred to as a "first semiconductor layer", the gate electrode 113 may be referred to as a "first gate electrode", the gate insulating layer 112 may be referred to as a "first gate insulating layer", the interlayer insulating layer 114 may be referred to as a "first insulating layer", and the source electrode 117a and the drain electrode 117b may be referred to as a "first electrode". Similarly, the oxide semiconductor layer 121 may be referred to as a "second semiconductor layer", the gate electrode 123 may be referred to as a "second gate electrode", the gate insulating layer 122 may be referred to as a "second gate insulating layer", the gate electrode 128 may be referred to as a "third gate electrode", the gate insulating layer 129 may be referred to as a "third gate insulating layer", the metal nitride layers 124c and 124d may be referred to as a "first metal nitride layer", and the source electrode 125c and the drain electrode 125d may be referred to as a "second electrode". Similarly, the interlayer insulating layer 116 may be referred to as a "second insulating layer." On the other hand, unlike the above, the gate electrode 123 may be referred to as a "third gate electrode", the gate insulating layer 122 may be referred to as a "third gate insulating layer", the gate electrode 128 may be referred to as a "second gate electrode", and the gate insulating layer 129 may be referred to as a "second gate insulating layer".

When expressed as described above, a configuration of semiconductor device 100 can be paraphrased as follows. The first gate electrode (the gate electrode 113) faces the first semiconductor layer (the semiconductor layer 111). The first gate insulating layer (the gate insulating layer 112) is present between the first semiconductor layer (the semiconductor layer 111) and the first gate electrode (the gate electrode 113). The first insulating layer (the interlayer insulating layer 114) is arranged above the first gate electrode (the gate electrode 113). The first electrodes (the source electrode 117a and the drain electrode 117b) are arranged in a region overlapping the first semiconductor layer (the semiconductor layer 111) in a plan view and are electrically connected to the first semiconductor layer (the semiconductor layer 111). The second semiconductor layer (the oxide semiconductor layer 121) is made of a material different from that of the first semiconductor layer (the semiconductor layer 111). The second semiconductor layer (the oxide semiconductor layer 121) is arranged above the first insulating layer (the interlayer insulating layer 114). The second gate electrode (the gate electrode 123) faces the second semiconductor layer (the oxide semiconductor layer 121) below the second semiconductor layer (the oxide semiconductor layer 121). The second gate insulating layer (the gate insulating layer 122) is present between the second semiconductor layer (the oxide semiconductor layer 121) and the second gate electrode (the gate electrode 123). The second electrodes (the source electrode 125c and the drain electrode 125d) are arranged in a region overlapping the second semiconductor layer (the oxide semiconductor layer 121) in a plan view and are electrically connected to the second semiconductor layer (the oxide semiconductor layer 121). The first metal nitride layers (the metal nitride layers 124c and 124d) are present between the second semiconductor layer (the oxide semiconductor layer 121) and the second electrodes (the source electrode 125c and the drain electrode 125d).

Similarly, the configuration of the semiconductor device 100 can be rephrased as follows. The first metal nitride layers (the metal nitride layers 124c and 124d) are in contact with the second semiconductor layer (the oxide semiconductor layer 121). The second insulating layer (the interlayer insulating layer 116) is arranged above the first insulating layer (the interlayer insulating layer 114). The third gate electrode (128) faces the second semiconductor layer (the oxide semiconductor layer 121) below the first insulating layer (the interlayer insulating layer 114). The third gate insulating layer (the gate insulating layer 129) is present between the second semiconductor layer (the oxide semiconductor layer 121) and the third gate electrode (the gate electrode 128). The second gate electrode (the gate electrode 123) is arranged above the second insulating layer (the interlayer insulating layer 116). The openings 115a and 115b are arranged in each of the first insulating layer (the interlayer insulating layer 114) and the second insulating layer (the interlayer insulating layer 116). The first electrodes (the source electrode 117a and the drain electrode 117b) are arranged above the second insulating layer (the interlayer insulating layer 116) and inside the openings 115a and 115b. The first electrodes (the source electrode 117a and the drain electrode 117b) are in the same layer as the second gate electrode (the gate electrode 123).

Conventionally, in the case where a transistor in which a poly silicon is used and a transistor in which an oxide semiconductor is used is formed on the same substrate, the following problem has arisen. In the case where the conductive layer in contact with the oxide semiconductor is processed into a desired shape, a surface of the oxide semiconductor may be damaged. The oxide semiconductor of the damaged region contains many oxygen vacancies. When an oxygen vacancy occurs in the oxide semiconductor, the off-leakage current of the transistor increases. In order to solve this problem, it is necessary to introduce a sufficient amount of oxygen into the oxide semiconductor by a heat treatment. However, this heat treatment causes the source electrode and the drain electrode to react with the oxide semiconductor, thereby reducing the on-state current of the transistor. Therefore, in an embodiment of the present invention, the metal nitride layer is arranged between the oxide semiconductor layer and the source electrode and between the oxide semiconductor layer and the drain electrode. The metal nitride layer suppresses the reaction between the oxide semiconductor and the electrode due to the heat treatment.

On the other hand, in the case where the metal nitride layer is arranged between the polysilicon and the source electrode and between the polysilicon and the drain electrode, nitrogen is implanted into the polysilicon when the metal nitride layer is deposited. This increases the contact resistance between the source and drain electrodes and the polysilicon via the metal nitride layer. According to an embodiment of the present invention, a structure in which the metal nitride layer is arranged only in the transistor in which an oxide semiconductor is used is exemplified. That is, the polysilicon is in direct contact with the source electrode and the drain electrode without interposing the metal nitride layer. On the other hand, the oxide semiconductor is connected to the source electrode and the drain electrode via the metal nitride layer. As a result, good characteristics can be obtained for each transistor.

### [1-2. Material of Each Member of Semiconductor Device 100]

A rigid substrate having light transmittance such as a glass substrate, a quartz substrate, a sapphire substrate, or the like, is used as the substrate 101. In the case where the substrate 101 needs to have flexibility, a substrate containing a resin such as a polyimide substrate, an acryl substrate, a siloxane substrate, or a fluororesin substrate is used as the substrate 101. In the case where the substrate containing a resin is used as the substrate 101, an impurity may be introduced into the resin in order to improve the heat resistance of the substrate 101. In particular, in the case where the semiconductor device 100 is a top-emission display, the substrate 101 does not need to be transparent, so that an impurity that degrades the transparency of the substrate 101 may be used. In the case where the semiconductor device 100 is used in an integrated circuit other than a display device, a semiconductor substrate such as a silicon substrate, a silicon carbide substrate, and a compound semiconductor substrate, or a substrate that does not have light transmittance such as a conductive substrate such as a stainless substrate is used as the substrate 101.

For example, low-temperature polysilicon, amorphous silicon, or single-crystal silicon is used as the semiconductor layer 111.

A common metal material is used as the conductive layer including the gate electrode 113, the source electrode 117a, the drain electrode 117b, the wiring 119, the gate electrodes 123, and 128, the source electrode 125c, and the drain electrode 125d. For example, aluminum (Al), titanium (Ti), chromium (Cr), cobalt (Co), nickel (Ni), molybdenum (Mo), hafnium (Hf), tantalum (Ta), tungsten (W), bismuth (Bi), silver (Ag), copper (Cu), and an alloy or compound thereof can be used. The above-described material may be used in a single layer or stacked layer as the conductive layer.

A common insulating material is used as the insulating layer including the gate insulating layer 112, the interlayer insulating layers 114, 116, and 126, and the gate insulating layers 122 and 129. For example, an inorganic insulating layer such as silicon oxide (SiOₓ), silicon oxynitride (SiOₓN_{y}), aluminum oxide (AlOₓ), aluminum oxynitride (AlOₓN_{y}), silicon nitride (SiNₓ), silicon nitride oxide (SiNₓO_{y}), aluminum nitride (AlNₓ), and aluminum nitride oxide (AlNₓO_{y}) is used as the insulating layer.

An insulating layer having a function of releasing oxygen by a heat treatment is used as the interlayer insulating layer 126. That is, an oxide insulating layer excessively containing oxygen is used as the interlayer insulating layer 126. For example, the temperature of the heat treatment in which the interlayer insulating layer 126 releases oxygen is 600°C or lower, 500°C or lower, 450°C or lower, or 400°C or lower. That is, for example, the interlayer insulating layer 126 releases oxygen at a heat treatment temperature performed in the manufacturing process of the semiconductor device 100 in the case where a glass substrate is used as the substrate 101.

An insulating layer with few defects is used as the gate insulating layers 112, 122 and 129. For example, in the case where a composition ratio of oxygen in the gate insulating layers 112, 122 and 129 and a composition ratio of oxygen in the insulating layer (hereinafter referred to as "other insulating layer") having the same composition as the gate insulating layers 112, 122 and 129 are compared, the composition ratio of oxygen in the gate insulating layers 112, 122 and 129 is closer to the stoichiometric ratio with respect to the insulating layer than the composition ratio of oxygen in the other insulating layer. Specifically, in the case where silicon oxide (SiOₓ) is used for each of the gate insulating layers 112, 122 and 129 and the interlayer insulating layer 126, the composition ratio of oxygen in the silicon oxide used as the gate insulating layers 112, 122 and 129 is closer to the stoichiometric ratio of silicon oxide as compared with the composition ratio of oxygen in the silicon oxide used as the interlayer insulating layer 126. For example, a layer in which no defects are observed when evaluated by an electron-spin resonance method (ESR) may be used as the gate insulating layers 112, 122 and 129.

SiOₓN_{y} and AlOₓN_{y} are a silicon compound and aluminum compound containing a smaller proportion (x > y) of nitrogen (N) than oxygen (O). SiNₓO_{y} and AlNₓO_{y} are a silicon compound and aluminum compound containing a smaller proportion (x > y) of oxygen than nitrogen.

A metal oxide having semiconductor properties may be used as the oxide semiconductor layer 121. For example, an oxide semiconductor containing indium (In), gallium (Ga), zinc (Zn), and oxygen (O) may be used as the oxide semiconductor layer 121. For example, an oxide semiconductor having a composition ratio of In : Ga : Zn : O = 1 : 1 : 1 : 4 may be used as the oxide semiconductor layer 121. However, the oxide semiconductor containing In, Ga, Zn and O used in the present embodiment is not limited to the above-described composition. An oxide semiconductor having a composition other than the above may be used as the oxide semiconductor. For example, an oxide semiconductor layer having a higher ratio of In than those described above may be used to improve mobility. On the other hand, in order to increase a bandgap and reduce the influence of light irradiation, an oxide semiconductor layer having a larger ratio of Ga than those described above may be used.

An oxide semiconductor containing two or more metals including indium (In) may be used as the oxide semiconductor layer 121. In this case, in the oxide semiconductor layer 121, the ratio of the indium element to the total amount of metal elements may be 50% or more in atomic ratio. Gallium (Ga), zinc (Zn), aluminum (Al), hafnium (Hf), yttrium (Y), zirconia (Zr), and lanthanoids may be used as the oxide semiconductor layer 121 in addition to indium. Elements other than those described above may be used as the oxide semiconductor layer 121.

Other elements may be added to the oxide semiconductor containing In, Ga, Zn, and O as the oxide semiconductor layer 121, and metal elements such as Al and Sn may be added. In addition to the above oxide semiconductor, an oxide semiconductor (IGO) containing In and Ga, an oxide semiconductor (IZO) containing In and Zn, an oxide semiconductor (ITZO) containing In, Sn, and Zn, and an oxide semiconductor containing In and W may be used as the oxide semiconductor layer 121.

In the case where the ratio of the indium element is large, the oxide semiconductor layer 121 is easily crystallized. As described above, the oxide semiconductor layer 121 having a polycrystalline structure can be obtained by using a material in which the ratio of the indium element to the total amount of metal elements is 50% or more. The oxide semiconductor layer 121 preferably contains gallium as a metal element other than indium. Gallium belongs to the same Group 13 element as indium. Therefore, the crystallinity of the oxide semiconductor layer 121 is not inhibited by gallium, and the oxide semiconductor layer 121 has a polycrystalline structure.

Although a detailed method for manufacturing the oxide semiconductor layer 121 will be described later, the oxide semiconductor layer 121 can be formed using a sputtering method. A composition of the oxide semiconductor layer 121 formed by the sputtering method depends on a composition of a sputtering target. Even when the oxide semiconductor layer 121 has a polycrystalline structure, the composition of the sputtering target substantially matches the composition of the oxide semiconductor layer 121. In this case, a composition of the metal element of the oxide semiconductor layer 121 can be specified based on a composition of the metal element of the sputtering target.

In the case where the oxide semiconductor layer 121 has a polycrystalline structure, the composition of the oxide semiconductor layer may be identified using an X-ray diffraction (XRD) method. Specifically, the composition of the metal element of the oxide semiconductor layer can be specified based on the crystalline structure and the lattice constant of the oxide semiconductor layer obtained by the XRD method. Furthermore, the composition of the metal element of the oxide semiconductor layer 121 can also be identified using a fluorescent X-ray analysis, or Electron Probe Micro Analyzer (EPMA) analysis, or the like. However, the oxygen element contained in the oxide semiconductor layer 121 may not be identified by these methods because the oxygen element varies depending on the sputtering process conditions.

As described above, the oxide semiconductor layer 121 may include an amorphous structure and may include a polycrystalline structure. The oxide semiconductor having a polycrystalline structure can be manufactured using a Poly-OS (Poly-crystalline Oxide Semiconductor) technique described below. In the following explanation, when distinguishing from the oxide semiconductor having an amorphous structure, the oxide semiconductor having a polycrystalline structure may be described as the Poly-OS.

Furthermore, instead of the oxide semiconductor layer 121, a semiconductor other than the oxide semiconductor may be used. In this case, the semiconductor used in place of the oxide semiconductor may be made of a different material or have a different composition from the semiconductor used in the semiconductor layer 111. That is, the transistor 110 has different characteristics from the transistor 120.

A metal oxide layer may be arranged between the gate insulating layer 129 and the oxide semiconductor layer 121. In this case, the metal oxide layer may be in contact with the oxide semiconductor layer 121. A metal oxide containing aluminum as a main component is used as the metal oxide layer. For example, an inorganic insulating layer such as aluminum oxide (AlOₓ), aluminum oxynitride (AlOₓN_{y}), and aluminum oxynitride (AlNₓO_{y}) is used as the metal oxide layer. The "metal oxide layer containing aluminum as a main component" means that the proportion of aluminum contained in the metal oxide layer is 1% or more of the entire metal oxide layer. The proportion of aluminum contained in the metal oxide layer may be 5% or more and 70% or less, 10% or more and 60% or less, or 30% or more and 50% or less of the entire metal oxide layer. The ratio may be a mass ratio or a weight ratio.

A nitride of a common metal material is used as the metal nitride layers 124c and 124d. For example, titanium nitride, molybdenum nitride, tungsten nitride, and tantalum nitride are used as the metal nitride layers 124c and 124d. The metal nitride layers 124c and 124d contain the same metal elements as the metal element contained in the source electrode 125c and the drain electrode 125d. For example, in the case where the structure of the source electrode 125c and the drain electrode 125d is Al/Ti (upper layer/lower layer), the metal nitride layers 124c and 124d may be titanium nitride.

In this case, the lower layer (Ti) included in the source electrode 125c and the drain electrode 125d (second electrode) may be referred to as a "first conductive layer", and the upper layer (Al) thereof may be referred to as a "second conductive layer". When expressed as described above, the configuration of the semiconductor device 100 can be paraphrased as follows. The second electrodes (the source electrode 125c and the drain electrode 125d) include the first conductive layer (Ti) and the second conductive layer (Al) on the first conductive layer (Ti). The first conductive layer (Ti) is in contact with the first metal nitride layers (metal nitride layer 124c and 124d). The first metal nitride layers (metal nitride layer 124c and 124d) (for example, TiN) contain the same metal element as the metal element contained in the first conductive layer (Ti).

### [1-3. Poly-OS Technique]

The Poly-OS contained in the oxide semiconductor layer is formed using sputtering and a heat treatment. Here, a method for forming the oxide semiconductor layer will be described.

First, the oxide semiconductor layer is deposited by sputtering. The deposited oxide semiconductor layer has an amorphous structure. In this case, the amorphous structure means a structure in which a long-range ordered structure does not exist and a periodic crystal lattice arrangement is not observed. For example, when the oxide semiconductor layer having an amorphous structure is observed using the XRD method, a certain peak based on the crystalline structure cannot be obtained in the diffractive pattern. The oxide semiconductor layer having an amorphous structure may have a short-range ordered structure in a micro region. However, such an oxide semiconductor layer does not exhibit characteristics of the Poly-OS and can therefore be classified as an oxide semiconductor layer having an amorphous structure.

In the Poly-OS techniques, the oxide semiconductor layer is deposited at a low temperature. For example, a temperature of a substrate on which the oxide semiconductor layer is deposited is 150°C or lower, preferably 100°C or lower, and more preferably 50°C or lower. When the temperature of the substrate is high during the deposition of the oxide semiconductor layer, microcrystals are likely to be generated in the oxide semiconductor to be deposited. The oxygen partial pressure in a chamber during deposition is 1% or more and 10% or less, preferably 1% or more and 5% or less, and more preferably 2% or more and 4% or less. When the oxygen partial pressure is high, microcrystals are generated in the oxide semiconductor layer due to excess oxygen contained in the oxide semiconductor. On the other hand, under the condition where the oxygen partial pressure is less than 1%, the composition of oxygen in the oxide semiconductor layer becomes uneven, and an oxide semiconductor layer containing a large amount of microcrystals or an oxide semiconductor layer which does not crystallize even when subjected to a heat treatment is formed.

Next, a heat treatment is performed on the oxide semiconductor layer deposited by sputtering. The heat treatment is performed in the atmosphere, but the atmosphere of the heat treatment is not limited to this. The temperature of the heat treatment is 300°C or higher and 500°C or lower, preferably 350°C or higher and 450°C or lower. The time of the heat treatment is 15 minutes or more and 120 minutes or less, preferably 30 minutes or more and 60 minutes or less. By performing the heat treatment, the oxide semiconductor layer having an amorphous structure is crystallized to form the oxide semiconductor layer containing the Poly-OS.

### [1-4. Characteristics of Oxide Semiconductor Layer 121]

Next, the characteristics of the oxide semiconductor layer used as the oxide semiconductor layer 121 and containing the Poly-OS will be described below.

The oxide semiconductor layer has excellent etching resistance. Specifically, the oxide semiconductor layer has a very low etching rate when etching using an etchant during wet etching. This means that the oxide semiconductor layer is hardly etched by the etchant. When the oxide semiconductor layer is etched at about 40°C using an etchant containing phosphoric acid as a main component, the etching rate is less than 3 nm/min, less than 2 nm/min, or less than 1 nm/min. The proportion of phosphoric acid in the etchant is 50% or more, 60% or more, or 70% or more. The etchant may contain nitric acid and acetic acid in addition to phosphoric acid. The temperature of about 40°C is a set temperature of a device holding the etchant, and the actual temperature of the etchant is 35°C or higher and 45°C or lower.

On the other hand, in the case where the oxide semiconductor layer is etched using the etchant containing phosphoric acid as a main component at a temperature of about 40°C with respect to an oxide semiconductor layer containing no Poly-OS, for example, the oxide semiconductor layer having an amorphous structure before the heat treatment, the etching rate is 100 nm/min or more.

In the case where the oxide semiconductor layer containing the Poly-OS is etched using 0.5% of a hydrofluoric acid solution at room temperature (for example, about 22°C), the etching rate is less than 5 nm/min, less than 4 nm/min, or less than 3 nm/min. In this case, the room temperature is 25°C±5°C. The actual temperature of the etchant at this time is 20°C or higher and 30°C or lower.

On the other hand, in the case where the oxide semiconductor layer containing no Poly-OS is etched using 0.5% of the hydrofluoric acid solution at room temperature, the etching rate is 15 nm/min or more.

Here, an embodiment of the oxide semiconductor layer is shown in Table 1. Table 1 shows the etching rates for a mixed acid etching solution and 0.5% of the hydrofluoric acid solution for each of the prepared samples. "Mixed acid AT-2F (product name)" manufactured by Rasa Industries, Ltd. was used as the mixed acid etching solution. The proportion of phosphoric acid in the mixed acid etching solution is about 65%. When each sample was etched, the temperature of the mixed acid etching solution was about 40°C and the temperature of 0.5% of the hydrofluoric acid solution was room temperature. In Table 1, Sample 1 is the oxide semiconductor layer containing the Poly-OS, Sample 2 is the oxide semiconductor layer having an amorphous structure before the heat treatment, and Sample 3 is an oxide semiconductor layer containing indium gallium zinc oxide (IGZO) with an indium ratio of less than 50%.

**[Table 1]**

| | Mixed acid etching solution | 0.5% hydrofluoric acid solution |
|---|---|---|
| Sample 1 | < 0. 1 nm/min | < 2 nm/min |
| Sample 2 | 111 nm/min | > 18 nm/min |
| Sample 3 | 162 nm/min | - |

As shown in Table 1, Sample 1 (the oxide semiconductor layer containing the Poly-OS) is hardly etched by the mixed acid etching solution, and only 2 nm/min is etched using 0.5% of the hydrofluoric acid solution. With respect to the mixed acid etching solution, the etching rate of Sample 1 is 1/100 or less of the etching rate of Sample 2 (the oxide semiconductor layer having an amorphous structure before the heat treatment). With respect to 0.5% of the hydrofluoric acid solution, the etching rate of Sample 1 is about 1/10 or less of the etching rate of Sample 2. With respect to the mixed acid etching solution, the etching rate of Sample 1 is 1/100 or less of the etching rate of Sample 3 (the oxide semiconductor layer containing IGZO with an indium ratio of less than 50%). That is, Sample 1 has significantly better etching resistance than Sample 2 and Sample 3.

Such excellent etching resistance of the oxide semiconductor layer containing Poly-OS is a property that cannot be obtained in the oxide semiconductor having a polycrystalline structure manufactured by the conventional process at 500°C or lower. Although the detailed mechanism for the excellent etching resistance of the oxide semiconductor layer containing the Poly-OS is unclear, the Poly-OS is considered to have a polycrystalline structure different from that of the conventional one.

As discussed above, the etching rate of the oxide semiconductor layer containing the Poly-OS to the etchant is very low. Therefore, it is very difficult to pattern the oxide semiconductor layer. Therefore, in the case where an island-shaped oxide semiconductor layer is formed, the oxide semiconductor layer having an amorphous structure before the heat treatment is patterned into an island shape, and thereafter, the oxide semiconductor layer patterned into the island shape is crystallized by performing the heat treatment. As a result, the island-shaped oxide semiconductor layer containing the Poly-OS is formed.

### [1-5. Method for Manufacturing Semiconductor Device 100]

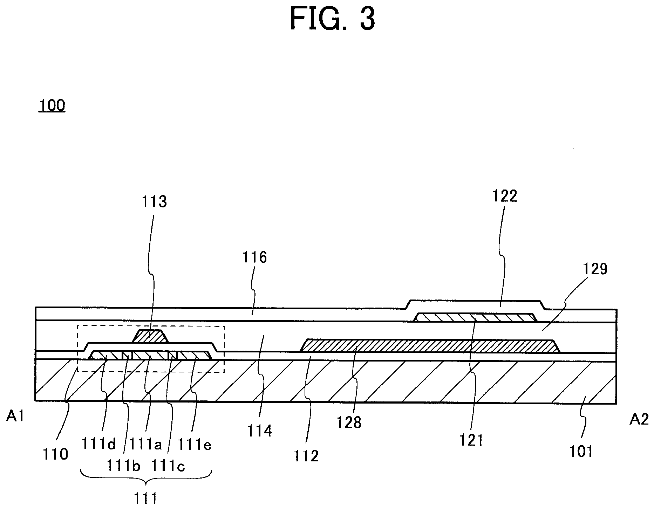

A method for manufacturing the semiconductor device according to an embodiment of the present invention will be described with reference to FIG. 3 to FIG. 6. FIG. 3 to FIG. 6 are cross-sectional views illustrating the method for manufacturing the semiconductor device according to an embodiment of the present invention.

As shown in FIG. 3, first, a semiconductor layer made of polysilicon is formed on a substrate 101, the semiconductor layer is processed by a photolithography process, and the semiconductor layer 111 is formed. Next, the gate insulating layer 112 is formed on the substrate 101 and the semiconductor layer 111. Next, a conductive layer is formed on the gate insulating layer 112, the conductive layer is processed by the photolithography process, and the gate electrode 113 overlapping the semiconductor layer 111 and the gate electrode 128 included in the transistor 120 are formed.

Next, using the gate electrode 113 as a mask, an impurity is implanted into the semiconductor layer 111 through the gate insulating layer 112. By implanting the impurity, the channel region 111a and other impurity regions are formed. Thereafter, a mask covering a region corresponding to the channel region 111a and the low-concentration impurity regions 111b and 111c is formed using a resist or the like, and additional impurities are implanted. The source region 111d and the drain region 111e are formed in a region adjacent to the low-concentration impurity regions 111b and 111c by the implantation of additional impurities. The low-concentration impurity regions 111b and 111c may be omitted. In this case, the channel region 111a is adjacent to the source region 111d and the drain region 111e.

Next, the interlayer insulating layer 114 is formed on the gate electrode 112 and the gate electrodes 113 and 128. Next, the oxide semiconductor layer is formed on the interlayer insulating layer 114, the semiconductor layer is processed by the photolithography process, and the oxide semiconductor layer 121 is formed. Next, an insulating layer is formed on the interlayer insulating layer 114 and the oxide semiconductor layer 121. The insulating layer has a function as the interlayer insulating layer 116 in the transistor 110, and a function as the gate insulation layer 122 in the transistor 120.

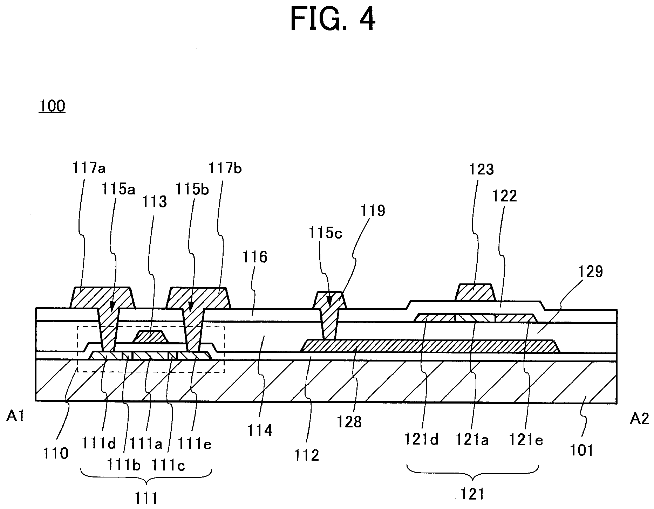

As shown in FIG. 4, the gate insulating layer 112 and the interlayer insulating layers 114 and 116 are processed by the photolithography process to form the openings 115a, 115b reaching the source region 111d and the drain region 111e of the semiconductor layer 111 and 115c reaching the gate electrode 128. Next, a conductive layer is deposited on the interlayer insulating layer 116 and inside the openings 115a, 115b and 115c. The source electrode 117a, the drain electrode 117b, the wiring 119 and the gate electrode 123 are formed by processing the deposited conductive layer by the photolithography process.

Next, using the gate electrode 123 as a mask, an impurity is implanted into the oxide semiconductor layer 121 through the gate insulating layer 122. By implanting the impurity, the channel region 121a, the source region 121d, and the drain region 121e are formed. A method of forming the source region 121d and the drain region 121e will be described later.

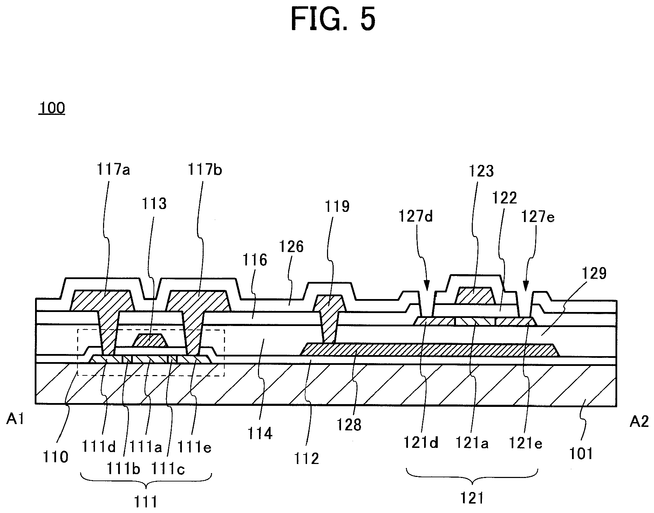

As shown in FIG. 5, the interlayer insulating layer 126 covering the source electrode 117a, the drain electrode 117b, the wiring 119 and the gate electrode 123 is formed on the interlayer insulating layer 116. By processing the interlayer insulating layers 116 and 126 by the photolithography process, the openings 127d and 127e that reach the source region 121d and the drain region 121e of the oxide semiconductor layer 121 are formed.

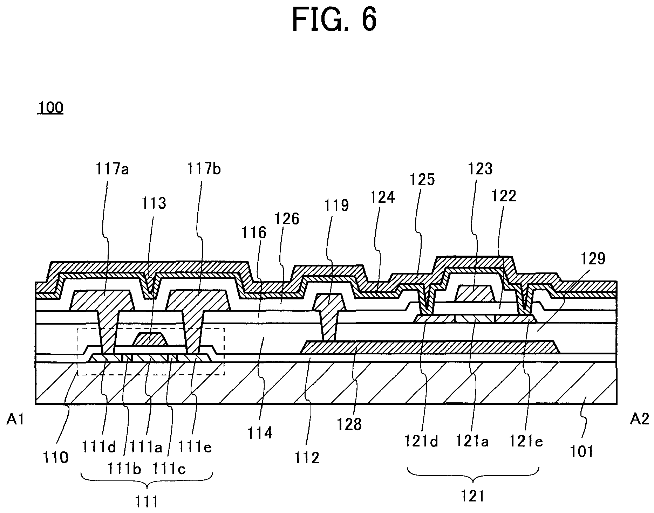

As shown in FIG. 6, the metal nitride layer 124 and a conductive layer 125 are deposited on the interlayer insulating layer 126 and inside the openings 127d and 127e. The metal nitride layers 124c and 124d, the source electrode 125c, and the drain electrode 125d shown in FIG. 2 are formed by processing the deposited metal nitride layer 124 and the conductive layer 125 by the photolithography process.

As described above, since the metal nitride layer 124c is arranged between the oxide semiconductor layer 121 and the source electrode 125c and the metal nitride layer 124d is arranged between the oxide semiconductor layer 121 and the drain electrode 125d, an increase in contact resistance can be suppressed. Further, since the semiconductor layer 111 is in contact with the source electrode 117a and the drain electrode 117b without a metal nitride layer, an increase in contact resistance can be suppressed.

### [1-6. Method of Forming Source Region 121d and Drain Region 121e]

A method of forming the source region 121d and the drain region 121e will be described with reference to FIG. 4. As shown in FIG. 4, ion implantation is performed on the oxide semiconductor layer 121 in a state where the gate insulating layer 122 and the gate electrode 123 are formed on the oxide semiconductor layer 121. For example, boron (B) is implanted as an impurity element into the oxide semiconductor layer 121 by the ion implantation. However, other impurity elements such as phosphorus (P) may be implanted into the oxide semiconductor layer 121 instead of boron.

In a region (the source region 121d and the drain region 121e) where the gate electrode 123 is not arranged, the impurity element passes through the gate insulating layer 122 and reaches the oxide semiconductor layer 121. However, since the impurity element is blocked by the gate electrode 123 in a region (the channel region 121a) where the gate electrode 123 is arranged, the impurity element does not reach the oxide semiconductor layer 121.

By the ion implantation described above, the source region 121d and the drain region 121e in which the impurity element is implanted are formed in the oxide semiconductor layer 121. In the oxide semiconductor layer 121 in the source region 121d and the drain region 121e, oxygen defects are formed by the implantation of the impurity element. Therefore, the resistance of the oxide semiconductor layer 121 in the source region 121d and the drain region 121e is reduced. In the oxide semiconductor layer 121 containing the Poly-OS, the source region 121d and the drain region 121e in which the impurity element is implanted may have crystallinity. This is also one of the characteristics of the Poly-OS. The crystal structure of each of the source region 121d and the drain region 121e is the same as the crystal structure of the channel region 121a.

### [2. Second Embodiment]

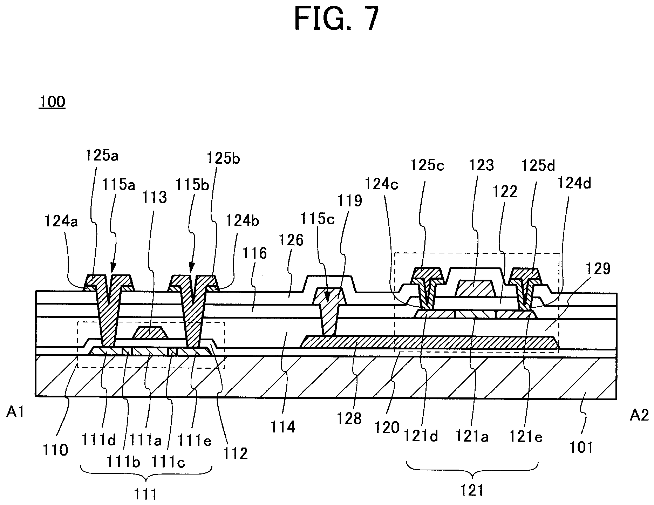

An example of a structure of the semiconductor device 100 according to an embodiment of the present invention will be described with reference to FIG. 7 to FIG. 11.

### [2-1. Configuration of Semiconductor Device]

FIG. 7 is a cross-sectional view when the semiconductor device 100 is cut along a line A1-A2 similar to FIG. 1. As shown in FIG. 1 and FIG. 7, the semiconductor device 100 according to an embodiment of the present invention includes the transistor 110 and the transistor 120 arranged on the transistor 110.

Since the configurations of the transistors 110 and 120 in FIG. 7 are the same as the configurations of the transistors 110 and 120 in FIG. 2, the description thereof will be omitted. As shown in FIG. 7, metal nitride layers 124a and 124b are arranged on the interlayer insulating layer 126. A source electrode 125a and a drain electrode 125b are arranged on the metal nitride layers 124a and 124b. The source electrode 125a and the drain electrode 125b are connected to the source region 111d and the drain region 111e via the openings 115a and 115b arranged in the interlayer insulating layers 114, 116, and 126. The metal nitride layers 124a and 124b are formed only on the upper surface of the interlayer insulating layer 126, and are not formed on the side wall of the openings 115a and 115b, an upper surface of the source region 111d, and an upper surface of the drain region 111e.

A material similar to the metal nitride layer 124c and 124d can be used as the metal nitride layers 124a and 124b. A material similar to the source electrode 125c and the drain electrode 125d can be used as the source electrode 125a and the drain electrode 125b.

In the above configuration, the metal nitride layers 124a and 124b may be referred to as a "second metal nitride layer", and the source electrode 125a and the drain electrode 125b may be referred to as a "first electrode". When expressed in this way, the configuration of the semiconductor device 100 can be paraphrased as follows. The second insulating layer (the interlayer insulating layer 116) is arranged above the first insulating layer (the interlayer insulating layer 114). The openings 115a and 115b are arranged in each of the first insulating layer (the interlayer insulating layer 114) and the second insulating layer (the interlayer insulating layer 116). The first electrodes (the source electrode 125a and the drain electrode 125b) are arranged above the second insulating layer (the interlayer insulating layer 116) and inside the openings 115a and 115b, and are in contact with the first semiconductor layer (the semiconductor layer 111). The second metal nitride layers (the metal nitride layers 124a and 124b) are arranged above the second insulating layer (the interlayer insulating layer 116) between the second insulating layer (the interlayer insulating layer 116) and the first electrodes (the source electrode 125a and the drain electrode 125b).

### [2-2. Method for Manufacturing Semiconductor Device 100]

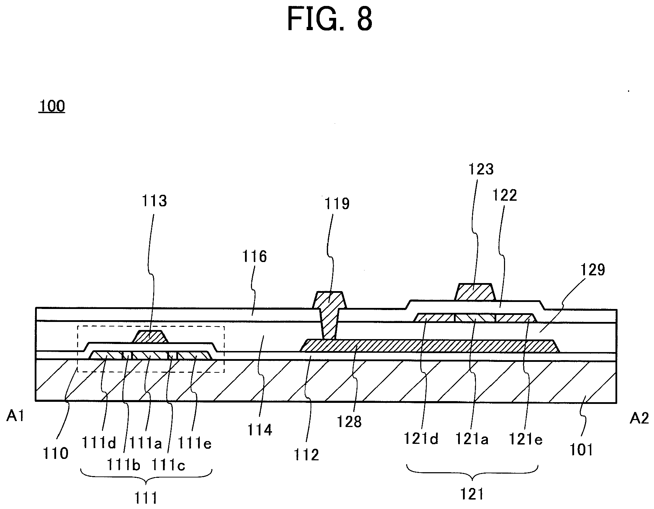

A method for manufacturing a semiconductor device according to an embodiment of the present invention will be described with reference to FIG. 8 to FIG. 11. FIG. 8 to FIG. 11 are cross-sectional views illustrating the method for manufacturing a semiconductor device according to an embodiment of the present invention.

As shown in FIG. 8, first, a semiconductor layer made of polysilicon is formed on the substrate 101, the semiconductor layer is processed by a photolithography process, and the semiconductor layer 111 is formed. Next, the gate insulating layer 112 is formed on the substrate 101 and the semiconductor layer 111. Next, a conductive layer is formed on the gate insulating layer 112, the conductive layer is processed by the photolithography process, and the gate electrode 113 overlapping the semiconductor layer 111 and the gate electrode 128 included in the transistor 120 are formed.

Next, using the gate electrode 113 as a mask, an impurity is implanted into the semiconductor layer 111 through the gate insulating layer 112. By implanting the impurity, the channel region 111a and other impurity regions are formed. Thereafter, a mask covering a region corresponding to the channel region 111a and the low-concentration impurity regions 111b and 111c is formed using a resist or the like, and additional impurities are implanted. The source region 111d and the drain region 111e are formed in a region adjacent to the low-concentration impurity regions 111b and 111c by the implantation of additional impurities. The low-concentration impurity regions 111b and 111c may be omitted. In this case, the channel region 111a is adjacent to the source region 111d and the drain region 111e.

Next, the interlayer insulating layer 114 is formed on the gate insulating layer 112 and the gate electrodes 113 and 128. Next, a semiconductor layer is formed on the interlayer insulating layer 114, the semiconductor layer is processed by a photolithography process, and the oxide semiconductor layer 121 is formed. Next, an insulating layer is formed on the interlayer insulating layer 114 and the oxide semiconductor layer 121. The insulating layer is an insulating layer that functions as the interlayer insulating layer 116 in the transistor 110 and the gate insulating layer 122 in the transistor 120.

Next, the interlayer insulating layers 114 and 116 are processed by the photolithography process to form the opening 115c reaching the gate electrode 128. Next, a conductive layer is deposited on the interlayer insulating layer 116 and inside the opening 115c. The wiring 119 and the gate electrode 123 are formed by processing the deposited conductive layer by the photolithography process.

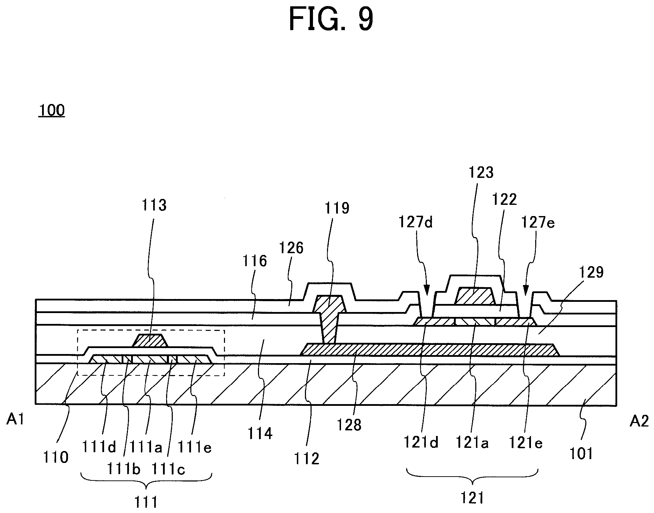

As shown in FIG. 9, the interlayer insulating layer 126 is formed on the interlayer insulating layer 116, the wiring 119, and the gate electrode 123. By processing the interlayer insulating layers 116 and 126 by the photolithography process, the openings 127d and 127e that reach the source region 121d and the drain region 121e of the oxide semiconductor layer 121 are formed.

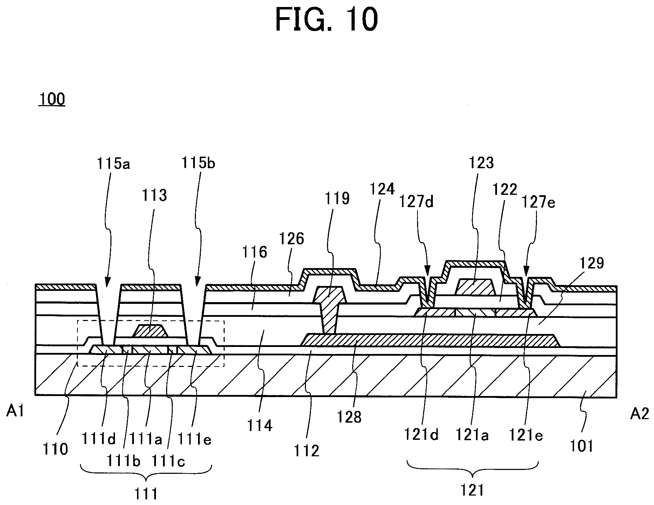

As shown in FIG. 10, first, the metal nitride layer 124 is formed on the interlayer insulating layer 126 and inside the openings 127d and 127e. The deposited metal nitride layer 124, the gate insulating layer 112, and the interlayer insulating layers 114, 116, and 126 are processed by the photolithography process to form the openings 115a and 115b that reach the source region 111d and the drain region 111e of the semiconductor layer 111.

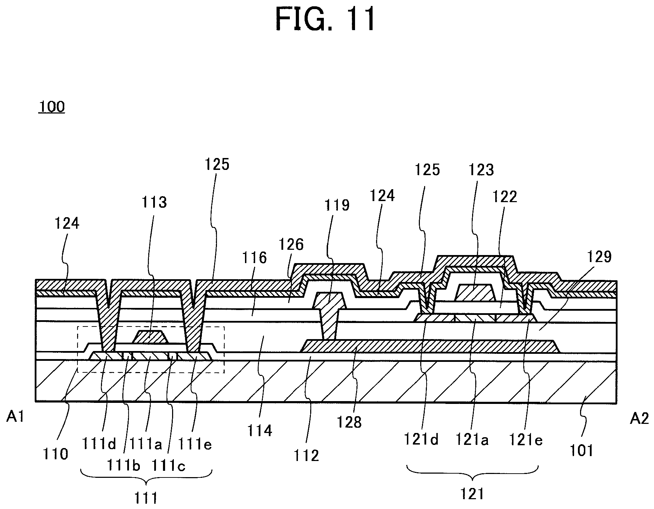

As shown in FIG. 11, a conductive layer 125 is deposited on the metal nitride layer 124 and inside the openings 115a and 115b. The source electrode 125a and the drain electrode 125b shown in FIG. 7 are formed by processing the deposited conductive layer 125 by the photolithography process.

As described above, since the metal nitride layer 124c is arranged between the oxide semiconductor layer 121 and the source electrode 125c and the metal nitride layer 124d is arranged between the oxide semiconductor layer 121 and the drain electrode 125d, an increase in contact resistance can be suppressed. Furthermore, since the semiconductor layer 111 is in contact with the source electrode 125a and the drain electrode 125b without interposing the metal nitride layer, an increase in contact resistance can be suppressed.

### [3. Third Embodiment]

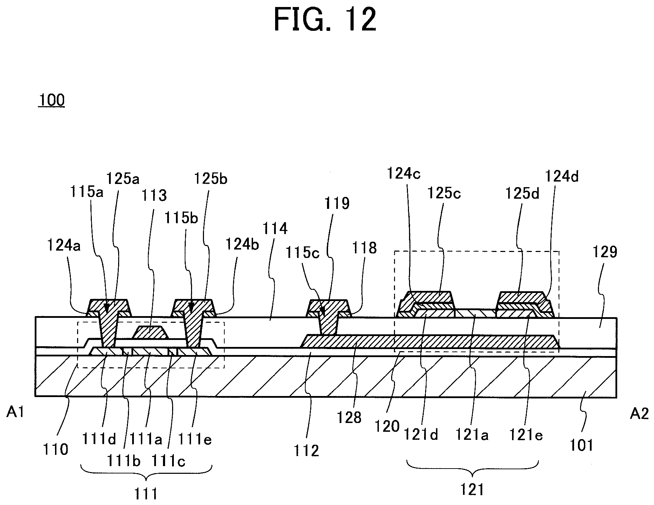

An example of a structure of the semiconductor device 100 according to an embodiment of the present invention will be described with reference to FIG. 12 to FIG. 15.

### [3-1. Configuration of Semiconductor Device]

FIG. 12 is a cross-sectional view when the semiconductor device 100 is cut along a line A1-A2 similar to FIG. 1. As shown in FIG. 1 and FIG. 12, the semiconductor device 100 according to an embodiment of the present invention includes the transistor 110 arranged on the substrate 101 and the transistor 120 arranged on the transistor 110.

A configuration of the transistor 110 shown in FIG. 12 is substantially the same as the configuration of the transistor 110 shown in FIG. 7. However, in FIG. 7, the insulating layer arranged between the semiconductor layer 111 and the source electrode 125a (and the drain electrode 125b) is the gate insulating layer 112 and the interlayer insulating layers 114, 116, and 126, whereas in FIG. 12, the insulating layer is the gate insulating layer 112 and the interlayer insulating layer 114. That is, in FIG. 12, the metal nitride layers 124a and 124b are in contact with an upper surface of the interlayer insulating layer 114.

As shown in FIG. 12, a metal nitride layer 118 is arranged on the interlayer insulating layer 114. The wiring 119 is arranged on the metal nitride layer 118. The wiring 119 is connected to the gate electrode 128 via the opening 115c arranged in the interlayer insulating layer 114. The metal nitride layer 118 is formed only on an upper surface of the interlayer insulating layer 114, and is not formed on the side walls of the opening 115c and an upper surface of the gate electrode 128.

As shown in FIG. 12, the oxide semiconductor layer 121 is arranged on the gate insulating layer 129. The metal nitride layers 124c and 124d are arranged on the upper surface and the side surface of the oxide semiconductor layer 121. The source electrode 125c and the drain electrode 125d are arranged on the upper surface of the metal nitride layers 124c and 124d.

The source electrode 125c and the metal nitride layer 124c are arranged in a region including the source region 121d. The drain electrode 125d and the metal nitride layer 124d are arranged in a region including the drain region 121e. The metal nitride layers 124c and 124d, the source electrode 125c, and the drain electrode 125d are not arranged in the channel region 121a. In other words, the oxide semiconductor layer 121 in the channel region 121a is exposed from the metal nitride layer and the conductive layer formed on the oxide semiconductor layer 121.

In the transistor 120 shown in FIG. 12, a voltage for controlling the channel region 121a is supplied to the gate electrode 128. That is, the transistor 120 is a bottom-gate transistor.

The above configuration can be paraphrased as follows. The first insulating layer (the interlayer insulating layer 114) is in the same layer as the third gate insulating layer (the gate insulating layer 129). The first gate electrode (the gate electrode 113) is in the same layer as the third gate electrode (the gate electrode 128). The first metal nitride layers (the metal nitride layers 124c and 124d) are in contact with the upper surface and the side surface of the second semiconductor layer (the oxide semiconductor layer 121). The openings 115a and 115b are arranged in first insulating layer (the interlayer insulating layer 114). The first electrodes (the source electrode 125a and the drain electrode 125b) are arranged above the first insulating layer (the interlayer insulating layer 114) and inside the openings 115a and 115b, and are in contact with the first semiconductor layer (the semiconductor layer 111). The second metal nitride layer (the metal nitride layers 124a and 124b) is arranged above the first insulating layer (the interlayer insulating layer 114) between the first insulating layer (the interlayer insulating layer 114) and the first electrodes (the source electrode 125a and the drain electrode 125b).

### [3-2. Method for Manufacturing Semiconductor Device 100]

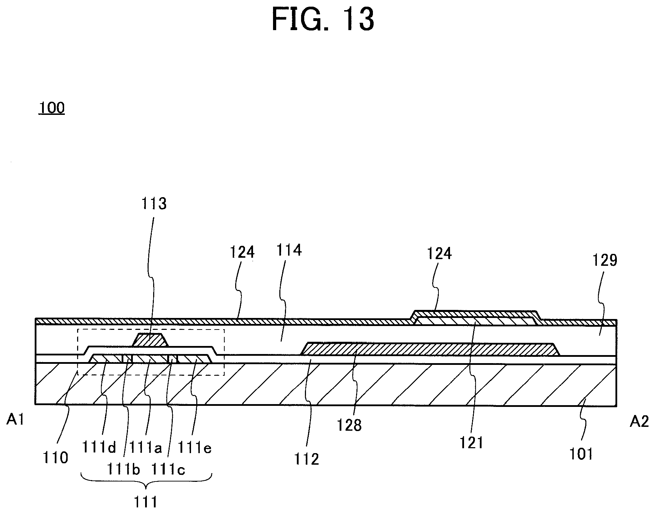

A method for manufacturing a semiconductor device according to an embodiment of the present invention will be described with reference to FIG. 13 to FIG. 15. FIG. 13 to FIG. 15 are cross-sectional views illustrating a method for manufacturing a semiconductor device according to an embodiment of the present invention.

Since the manufacturing method shown in FIG. 13 is the same as the manufacturing method shown in FIG. 3 up to the step of forming the oxide semiconductor layer 121, the explanation thereof will be omitted. As shown in FIG. 13, after the oxide semiconductor layer 121 is formed, the metal nitride layer 124 is deposited on the interlayer insulating layer 114 and on the oxide semiconductor layer 121.

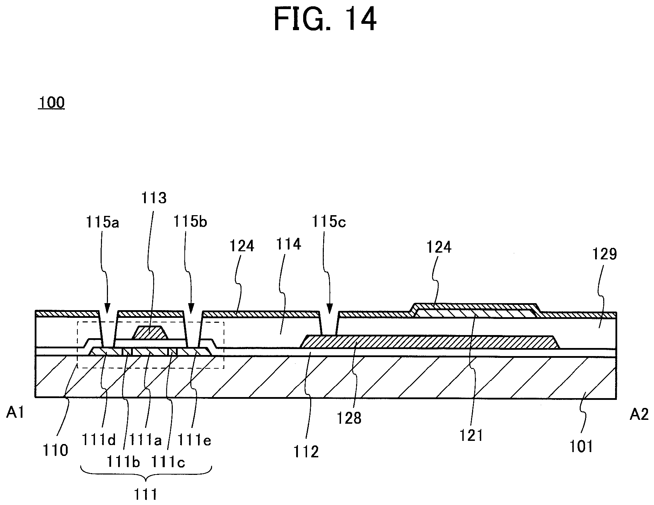

As shown in FIG. 14, the deposited metal nitride layers 124, the gate insulating layer 112, and the interlayer insulating layer 114 are processed by the photolithography process to form the openings 115a, 115b reaching the source region 111d and the drain region 111e of the semiconductor layer 111 and 115c reaching the gate electrode 128.

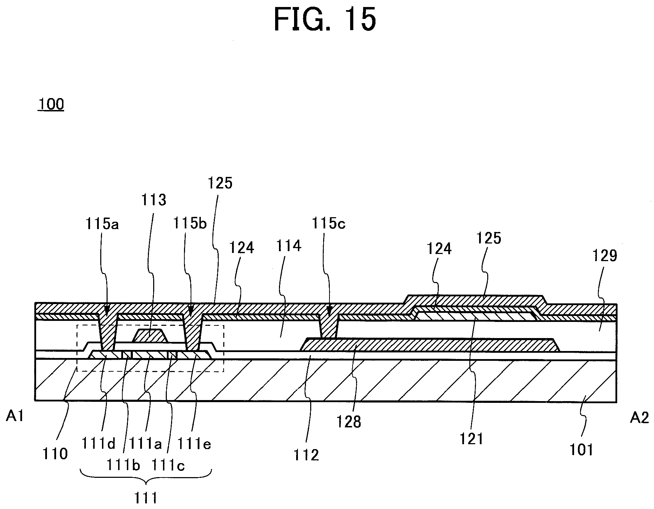

As shown in FIG. 15, the conductive layer 125 is deposited on the metal nitride layers 124 and inside the openings 115a, 115b and 115c. By processing the deposited conductive layer 125 by the photolithography process, the metal nitride layers 124a, 124b, 124c, 124d and 118, the source electrodes 125a and 125c, the drain electrodes 125b and 125d, and the wiring 119 shown in FIG. 12 are formed.

As described above, since the metal nitride layer 124c is arranged between the oxide semiconductor layer 121 and the source electrode 125c and the metal nitride layer 124d is arranged between the oxide semiconductor layer 121 and the drain electrode 125d, an increase in contact resistance can be suppressed. Furthermore, since the semiconductor layer 111 is in contact with the source electrode 125a and the drain electrode 125b without interposing the metal nitride layer, an increase in contact resistance can be suppressed.

### [4. Fourth Embodiment]

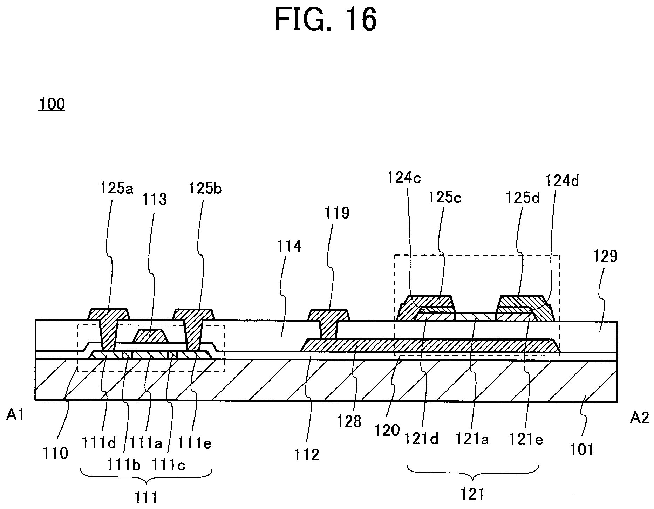

An example of a structure of the semiconductor device 100 according to an embodiment of the present invention will be described with reference to FIG. 16 to FIG. 19.

### [4-1. Configuration of Semiconductor Device]

FIG. 16 is a cross-sectional view when the semiconductor device 100 is cut along a line A1-A2 similar to FIG. 1. As shown in FIG. 1 and FIG. 16, the semiconductor device 100 according to an embodiment of the present invention includes the transistor 110 and the transistor 120 arranged on the transistor 110.

Although a configuration of the transistors 110 and 120 shown in FIG. 16 is similar to the configuration of each of the transistors 110 and 120 shown in FIG. 12, the configurations are different from each other in the region where the metal nitride layers are arranged.

In the transistor 110 shown in FIG. 12, the metal nitride layers 124a and 124b are arranged between the source electrode 125a and the interlayer insulating layer 114, and between the drain electrode 125b and the interlayer insulating layer 114. However, in the transistor 120 shown in FIG. 16, the metal nitride layer is not arranged in the same position as described above. That is, the source electrode 125a and the drain electrode 125b are in contact with the upper surface of the interlayer insulating layer 114.

Similarly, in the transistor 120 shown in FIG. 12, the metal nitride layer 118 is arranged between the wiring 119 and the interlayer insulating layer 114, but in the transistor 120 shown in FIG. 16, the metal nitride layer is not arranged in the same position as described above. That is, the source electrode 125a and the drain electrode 125b are in contact with the upper surface of the interlayer insulating layer 114.

Similarly, in the transistor 120 shown in FIG. 12, the metal nitride layers 124c and 124d are formed from the upper surface of the oxide semiconductor layer 121 to the upper surface of the interlayer insulating layer 114 beyond the side surface of the oxide semiconductor layer 121, but in the transistor 120 shown in FIG. 16, the metal nitride layers 124c and 124d are formed only on the upper surface of the oxide semiconductor layer 121. That is, the metal nitride layers 124c and 124d are not formed on the side surface of the oxide semiconductor layer 121. The side surface of the oxide semiconductor layer 121 is in contact with the source electrode 125c and the drain electrode 125d arranged above the metal nitride layers 124c and 124d.

### [4-2. Method for Manufacturing Semiconductor Device 100]

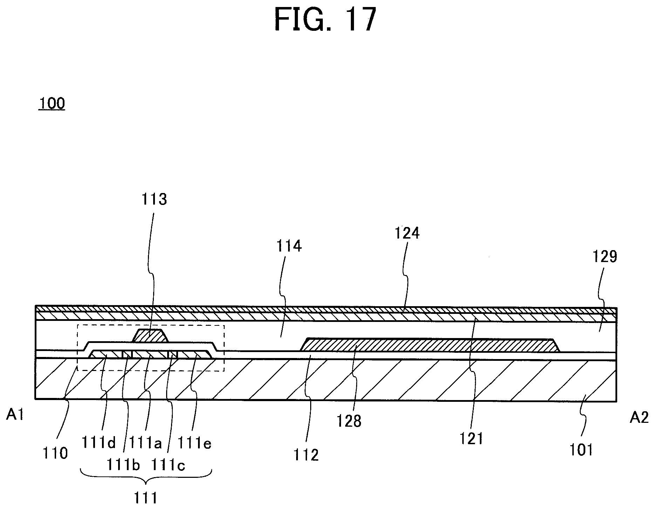

A method for manufacturing a semiconductor device according to an embodiment of the present invention will be described with reference to FIG. 17 to FIG. 19. FIG. 17 to FIG. 19 are cross-sectional views illustrating a method for manufacturing a semiconductor device according to an embodiment of the present invention.

Since the manufacturing method shown in FIG. 17 is the same as the manufacturing method shown in FIG. 3 up to the step of forming the interlayer insulating layer 114, the explanation thereof will be omitted. After the interlayer insulating layer 114 is formed, the oxide semiconductor layer 121 and the metal nitride layer 124 are deposited on the interlayer insulating layer 114.

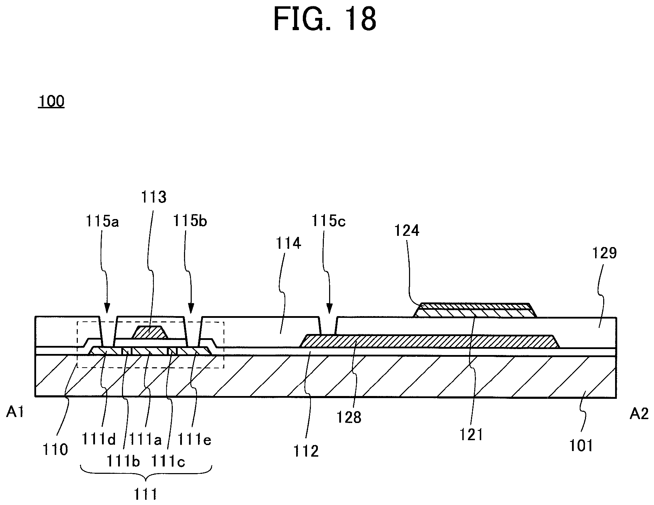

As shown in FIG. 18, the deposited oxide semiconductor layer 121 and the metal nitride layer 124 are processed by a photolithography process. Next, the gate insulating layer 112 and the interlayer insulating layer 114 are processed by the photolithography process to form the openings 115a and 115b reaching the source region 111d and the drain region 111e of the semiconductor layer 111 and the opening 115c reaching the gate electrode 128.

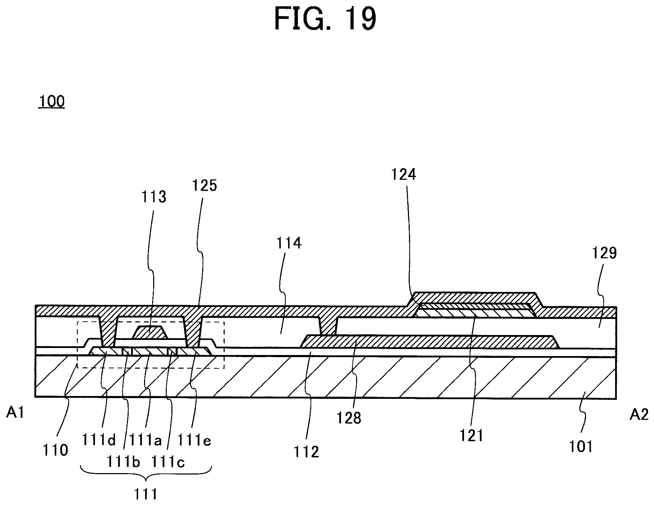

As shown in FIG. 19, the conductive layer 125 is deposited on the metal nitride layer 124 and inside the openings 115a, 115b, and 115c. The deposited conductive layer 125 is processed by the photolithography process to form the metal nitride layers 124c and 124d, the source electrodes 125a and 125c, the drain electrodes 125b and 125d, and the wiring 119 shown in FIG. 16.

As described above, since the metal nitride layer 124c is arranged between the oxide semiconductor layer 121 and the source electrode 125c and the metal nitride layer 124d is arranged between the oxide semiconductor layer 121 and the drain electrode 125d, an increase in contact resistance can be suppressed. Furthermore, since the semiconductor layer 111 is in contact with the source electrode 125a and the drain electrode 125b without interposing the metal nitride layer, an increase in contact resistance can be suppressed.

### [5. Fifth Embodiment]

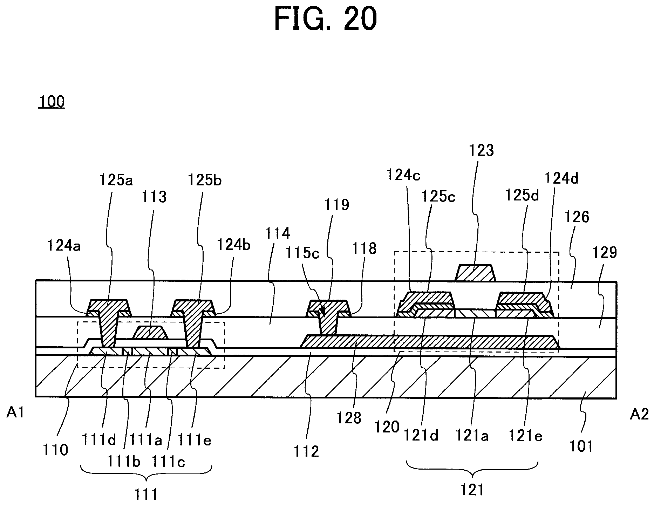

An example of a structure of the semiconductor device 100 according to an embodiment of the present invention will be described with reference to FIG. 20.

### [5-1. Configuration of Semiconductor Device]

FIG. 20 is a cross-sectional view when the semiconductor device 100 is cut along a line A1-A2 similar to FIG. 1. As shown in FIG. 1 and FIG. 20, the semiconductor device 100 according to an embodiment of the present invention includes the transistor 110 arranged on the substrate 101 and the transistor 120 arranged on the transistor 110.

A configuration of the transistor 120 shown in FIG. 20 is similar to the configuration of each of the transistors 120 shown in FIG. 12, but is different from the transistor 120 shown in FIG. 12 in that the gate electrode 123 is arranged above the oxide semiconductor layer 121. In the transistor 120 shown in FIG. 20, a voltage for controlling the channel region 121a is supplied to the gate electrodes 123 and 128. That is, the transistor 120 is a dual-gate transistor. In the transistor 120, the voltage for controlling the channel region 121a may not be supplied to the gate electrode 128, and a predetermined fixed voltage may be supplied to the gate electrode 128. The gate electrode 128 may be floating. The transistor 120 may be a top-gate transistor in which the gate electrode 128 is omitted and the voltage for controlling the channel region 121a is supplied to the gate electrode 123.

The transistor 120 shown in FIG. 20 is obtained by forming the interlayer insulating layer 126 on the transistor 120 shown in FIG. 12, forming the conductive layer on the interlayer insulating layer 126, and processing the conductive layer into the gate electrode 123 by the photolithography process. The interlayer insulating layer 126 functions as the gate insulating layer.

Even in the semiconductor device 100 according to the present embodiment, the same advantages as those of the other embodiments described above can be obtained.

Each of the embodiments described above as an embodiment of the present invention can be appropriately combined and implemented as long as no contradiction is caused.

Furthermore, it is understood that, even if the effect is different from those provided by each of the above-described embodiments, the effect obvious from the description in the specification or easily predicted by persons ordinarily skilled in the art is apparently derived from the present invention.

### REFERENCES SIGNS LIST

100: semiconductor device, 101: substrate, 110: transistor, 111: semiconductor layer, 111a: channel region, 111b, 111c: low-concentration impurity regions, 111d: source region, 111e: drain region, 112: gate insulating layer, 113: gate electrode, 114: interlayer insulating layer, 115a, 115b, 115c: opening, 116: interlayer insulating layer, 117a: source electrode, 117b: drain electrode, 118: metal nitride layer, 119: wiring, 120: transistor, 121: oxide semiconductor layer, 121a: channel region, 121d: source region, 121e: drain region, 122: gate insulating layers, 123: gate electrode, 124: metal nitride layer, 125: conductive layer, 125a, 125c: source electrode, 125b, 125d: drain electrode, 126: interlayer insulating layer, 127d, 127e: opening, 128: gate electrode, 129: metal nitride layer

## Claims

1. A semiconductor device comprising:
a first semiconductor layer(111);
a first gate electrode (113) facing the first semiconductor layer;
a first gate insulating layer between the first semiconductor layer and the first gate electrode;
a first insulating layer (112) arranged above the first gate electrode;
a first electrode (117) arranged in a region overlapping the first semiconductor layer in a plan view, and electrically connected to the first semiconductor layer;
a second semiconductor layer (121) arranged above the first insulating layer and made of a different material from the first semiconductor layer;
a second gate electrode (123) facing the second semiconductor layer;
a second gate insulating layer between the second semiconductor layer and the second gate electrode;
a second electrode (125) arranged in a region overlapping the second semiconductor layer in a plan view, and electrically connected to the second semiconductor layer; and
a first metal nitride layer (124) between the second semiconductor layer and the second electrode,
wherein
the second semiconductor layer (121) is polycrystalline, and
an etching rate of the second semiconductor layer (121) with respect to an etchant including phosphoric acid as a main component is less than 3 nm/min at 40 °C.

2. The semiconductor device according to claim 1, wherein the first metal nitride layer contains the same metal element as a metal element contained in the second electrode.

3. The semiconductor device according to at least one of the previous claims, wherein
the second electrode includes a first conductive layer and a second conductive layer above the first conductive layer,
the first conductive layer is in contact with the first metal nitride layer, and
the first metal nitride layer contains the same metal element as a metal element contained in the first conductive layer.

4. The semiconductor device according to at least one of the previous claims, wherein the first metal nitride layer is in contact with the second semiconductor.

5. The semiconductor device according to at least one of the previous claims, further comprising:
a second insulating layer above the first insulating layer;
a third gate electrode facing the second semiconductor layer below the first insulating layer; and
a third gate insulating layer between the second semiconductor layer and the third gate electrode,
wherein
the second gate electrode is arranged above the second insulating layer,
each of the first insulating layer and the second insulating layer has an opening,
the first electrode is arranged above the second insulating layer and inside the opening, and
the first electrode is in the same layer as the second gate electrode.

6. The semiconductor device according to at least one of the previous claims, further comprising:
a second metal nitride layer; and
a second insulating layer above the first insulating layer,
wherein
each of the first insulating layer and the second insulating layer has an opening, and
the first electrode is arranged above the second insulating layer and inside the opening, and is in contact with the first semiconductor layer.

7. The semiconductor device according to claim 6, wherein the second metal nitride layer is arranged above the second insulating layer between the second insulating layer and the first electrode.

8. The semiconductor device according to claim 5, wherein
the first insulating layer is in the same layer as the third gate insulating layer, and
the first gate electrode is in the same layer as the third gate electrode.

9. The semiconductor device according to claim 8, wherein the first metal nitride layer is in contact with an upper surface and a side surface of the second semiconductor layer.

10. The semiconductor device according to claim 8, further comprising a second metal nitride layer,
wherein
the first insulating layer has an opening, and
the first electrode is arranged above the first insulating layer and inside the opening, and is in contact with the first semiconductor layer.

11. The semiconductor device according to claim 10, wherein the second metal nitride layer is arranged above the first insulating layer between the first insulating layer and the first electrode.

## Patentansprüche

1. Halbleitervorrichtung, die umfasst:
eine erste Halbleiterschicht (111);
eine erste Gate-Elektrode (113), die der ersten Halbleiterschicht zugewandt ist;
eine erste Gate-Isolierschicht zwischen der ersten Halbleiterschicht und der ersten Gate-Elektrode;
eine erste Isolierschicht (112), die über der ersten Gate-Elektrode angeordnet ist;
eine erste Elektrode (117), die in einem Bereich angeordnet ist, der die erste Halbleiterschicht in einer Draufsicht überdeckt, und mit der ersten Halbleiterschicht elektrisch verbunden ist;
eine zweite Halbleiterschicht (121), die über der ersten Isolierschicht angeordnet ist und aus einem anderen Material als die erste Halbleiterschicht hergestellt ist;
eine zweite Gate-Elektrode (123), die der zweiten Halbleiterschicht zugewandt ist;
eine zweite Gate-Isolierschicht zwischen der zweiten Halbleiterschicht und der zweiten Gate-Elektrode;
eine zweite Elektrode (125), die in einem Bereich angeordnet ist, der die zweite Halbleiterschicht in einer Draufsicht überdeckt, und mit der zweiten Halbleiterschicht elektrisch verbunden ist; und
eine erste Metallnitridschicht (124) zwischen der zweiten Halbleiterschicht und der zweiten Elektrode,
wobei
die zweite Halbleiterschicht (121) polykristallin ist und
eine Ätzrate der zweiten Halbleiterschicht (121) in Bezug auf ein Ätzmittel, das Phosphorsäure als eine Hauptkomponente enthält, kleiner als 3 nm/min bei 40°C ist.

2. Halbleitervorrichtung nach Anspruch 1, wobei die erste Metallnitridschicht dasselbe Metallelement wie ein Metallelement, das in der zweiten Elektrode enthalten ist, enthält.

3. Halbleitervorrichtung nach mindestens einem der vorhergehenden Ansprüche, wobei
die zweite Elektrode eine erste leitende Schicht und eine zweite leitende Schicht über der ersten leitenden Schicht enthält,
wobei die erste leitendende Schicht mit der ersten Metallnitridschicht in Kontakt ist und
die erste Metallnitridschicht dasselbe Metallelement wie ein Metallelement, das in der ersten leitenden Schicht enthalten ist, enthält.

4. Halbleitervorrichtung nach mindestens einem der vorhergehenden Ansprüche, wobei die erste Metallnitridschicht mit dem zweiten Halbleiter in Kontakt ist.

5. Halbleitervorrichtung nach mindestens einem der vorhergehenden Ansprüche, die ferner umfasst:
eine zweite Isolierschicht über der ersten Isolierschicht;
eine dritte Gate-Elektrode, die der zweiten Halbleiterschicht zugewandt ist, unter der ersten Isolierschicht; und
eine dritte Gate-Isolierschicht zwischen der zweiten Halbleiterschicht und der dritten Gate-Elektrode,
wobei
die zweite Gate-Elektrode über der zweiten Isolierschicht angeordnet ist,
die erste Isolierschicht und die zweite Isolierschicht eine Öffnung besitzen,
die erste Elektrode über der zweiten Isolierschicht und innerhalb der Öffnung angeordnet ist und
die erste Elektrode in derselben Schicht wie die zweite Gate-Elektrode ist.

6. Halbleitervorrichtung nach mindestens einem der vorhergehenden Ansprüche, die ferner umfasst:
eine zweite Metallnitridschicht; und
eine zweite Isolierschicht über der ersten Isolierschicht,
wobei
die erste Isolierschicht und die zweite Isolierschicht eine Öffnung besitzen und
die erste Elektrode über der zweiten Isolierschicht und innerhalb der Öffnung angeordnet ist und mit der ersten Halbleiterschicht in Kontakt ist.

7. Halbleitervorrichtung nach Anspruch 6, wobei die zweite Metallnitridschicht über der zweiten Isolierschicht zwischen der zweiten Isolierschicht und der ersten Elektrode angeordnet ist.

8. Halbleitervorrichtung nach Anspruch 5, wobei
die erste Isolierschicht in derselben Schicht wie die dritte Gate-Isolierschicht ist und
die erste Gate-Elektrode in derselben Schicht wie die dritte Gate-Elektrode ist.

9. Halbleitervorrichtung nach Anspruch 8, wobei die erste Metallnitridschicht mit einer oberen Fläche und einer Seitenfläche der zweiten Halbleiterschicht in Kontakt ist.

10. Halbleitervorrichtung nach Anspruch 8, die ferner eine zweite Metallnitridschicht umfasst,
wobei
die erste Isolierschicht eine Öffnung besitzt und
die erste Elektrode über der ersten Isolierschicht und innerhalb der Öffnung angeordnet ist und mit der ersten Halbleiterschicht in Kontakt ist.

11. Halbleitervorrichtung nach Anspruch 10, wobei die zweite Metallnitridschicht über der ersten Isolierschicht zwischen der ersten Isolierschicht und der ersten Elektrode angeordnet ist.

## Revendications

1. Dispositif semi-conducteur comprenant :
une première couche semi-conductrice (111) ;
une première électrode de grille (113) tournée vers la première couche semi-conductrice ;
une première couche d'isolation de grille entre la première couche semi-conductrice et la première électrode de grille ;
une première couche d'isolation (112) agencée au-dessus de la première électrode de grille ;
une première électrode (117) agencée dans une région en chevauchement avec la première couche semi-conductrice dans une vue en plan, et connectée électriquement à la première couche semi-conductrice ;
une seconde couche semi-conductrice (121) agencée au-dessus de la première couche d'isolation et faite à partir d'un matériau différent de la première couche semi-conductrice ;
une deuxième électrode de grille (123) tournée vers la seconde couche semi-conductrice ;
une deuxième couche d'isolation de grille entre la seconde couche semi-conductrice et la deuxième électrode de grille ;
une deuxième électrode (125) agencée dans une région en chevauchement avec la seconde couche semi-conductrice dans une vue en plan, et connectée électriquement à la seconde couche semi-conductrice ; et
une première couche de nitrure métallique (124) entre la seconde couche semi-conductrice et la deuxième électrode,
dans lequel
la seconde couche semi-conductrice (121) est polycristalline, et
une vitesse de gravure de la seconde couche semi-conductrice (121) par rapport à un agent de gravure incluant un acide phosphorique à titre de composant principal est inférieure à 3 nm/min à 40 °C.

2. Dispositif semi-conducteur selon la revendication 1, dans lequel la première couche de nitrure métallique contient le même élément métallique qu'un élément métallique contenu dans la deuxième électrode.

3. Dispositif semi-conducteur selon l'une au moins des revendications précédentes, dans lequel
la deuxième électrode inclut une première couche conductrice et une seconde couche conductrice au-dessus de la première couche conductrice, la première couche conductrice est en contact avec la première couche de nitrure métallique, et
la première couche de nitrure métallique contient le même élément métallique qu'un élément métallique contenu dans la première couche conductrice.

4. Dispositif semi-conducteur selon l'une au moins des revendications précédentes, dans lequel la première couche de nitrure métallique est en contact avec le second semi-conducteur.

5. Dispositif semi-conducteur selon l'une au moins des revendications précédentes, comprenant en outre :
une deuxième couche d'isolation au-dessus de la première couche d'isolation ;
une troisième électrode de grille tournée vers la seconde couche semi-conductrice en dessous de la première couche d'isolation ; et
une troisième couche d'isolation de grille entre la seconde couche semi-conductrice et la troisième électrode de grille,
dans lequel
la deuxième électrode de grille est agencée au-dessus de la deuxième couche d'isolation,
chacune de la première couche d'isolation et de la deuxième couche d'isolation a une ouverture,
la première électrode est agencée au-dessus de la deuxième couche d'isolation et à l'intérieur de l'ouverture, et
la première électrode est dans la même couche que la deuxième électrode de grille.

6. Dispositif semi-conducteur selon l'une au moins des revendications précédentes, comprenant en outre :
une seconde couche de nitrure métallique ; et
une deuxième couche d'isolation au-dessus de la première couche d'isolation,
dans lequel
chacune de la première couche d'isolation et de la deuxième couche d'isolation a une ouverture, et
la première électrode est agencée au-dessus de la deuxième couche d'isolation et à l'intérieur de l'ouverture, et est en contact avec la première couche semi-conductrice.

7. Dispositif semi-conducteur selon la revendication 6, dans lequel la seconde couche de nitrure métallique est agencée au-dessus de la deuxième couche d'isolation entre la deuxième couche d'isolation et la première électrode.

8. Dispositif semi-conducteur selon la revendication 5, dans lequel
la première couche d'isolation est dans la même couche que la troisième couche d'isolation de grille, et
la première électrode de grille est dans la même couche que la troisième électrode de grille.

9. Dispositif semi-conducteur selon la revendication 8, dans lequel la première couche de nitrure métallique est en contact avec une surface supérieure et une surface latérale de la seconde couche semi-conductrice.

10. Dispositif semi-conducteur selon la revendication 8, comprenant en outre une seconde couche de nitrure métallique,
dans lequel
la première couche d'isolation a une ouverture, et
la première électrode est agencée au-dessus de la première couche d'isolation et à l'intérieur de l'ouverture, et est en contact avec la première couche semi-conductrice.

11. Dispositif semi-conducteur selon la revendication 10, dans lequel la seconde couche de nitrure métallique est agencée au-dessus de la première couche d'isolation entre la première couche d'isolation et la première électrode.
